# EUROPÄISCHE PATENTSCHRIFT

(11) **EP 2 492 368 B1**
(45) Veröffentlichungstag und Bekanntmachung des Hinweises auf die Patenterteilung: **07.04.2021**
(21) Anmeldenummer: 12000166.4
(22) Anmeldetag: 12.01.2012
(51) Int. Cl.: C23C 14/34, H01J 37/34, C23C 4/06, C23C 4/123, C22C 28/00, C23C 4/08

(54) **Rohrförmiges Sputtertarget**
Tubular sputter target
Cible de pulvérisation tubulaire

(30) Priorität: 22.02.2011 DE 102011012034
(43) Veröffentlichungstag der Anmeldung: 29.08.2012
(73) Patentinhaber: Materion Advanced Materials Germany GmbH, 63755 Alzenau (DE)
(72) Erfinder: Simons, Christoph, Dr., 63599 Biebergemünd (DE); Schlott, Martin, Dr., 63075 Offenbach (DE); Heindel, Josef, 63512 Hainburg (DE); Stahr, Carl-Christoph, 63796 Kahl am Main (DE)
(74) Vertreter: Kador & Partner PartG mbB

(56) Entgegenhaltungen:
- EP-A1- 2 216 424
- EP-A1- 2 233 604
- EP-A1- 2 287 356
- DE-C1- 10 063 383
- JP-A- H0 726 373
- US-A1- 2004 063 320
- US-A1- 2008 271 779

## Beschreibung

Die Erfindung betrifft ein rohrförmiges Sputtertarget mit einem Trägerrohr und einem auf dem Trägerrohr angeordneten Sputtermaterial auf der Basis von Indium.

Indium Rohrtargets werden zum Beispiel zur Beschichtung von CulnGa-Absorberschichten für Dünnschicht-Photovoltaik-Zellen auf CuInGaS₂ oder CuInGaSe₂-Basis verwendet. Beim Indium-Sputtern bilden sich häufig nadelförmige Strukturen auf der Sputtertargetoberfläche, die in Abhängigkeit von der Kornorientierung damit zu unterschiedlichen Sputterraten und damit ungleichmäßiger Schichtdicke führen (M. Weigert, The Challenge of CIGS Sputtering, Heraeus Thin Film Materials No.11, April 2008).

Bisher wurden entsprechende Rohrtargets über einen einfachen Gießprozess hergestellt, wie zum Beispiel in EP 1186682 B1 beschrieben. Wegen der für die CIGS-Anwendung nötigen hohen metallischen Reinheit (99,99 bis 99,999%) weisen diese Sputtertargets ein sehr grobes Gefüge auf, das dann zu den oben genannten Problemen führen kann Weiterer relevanter Stand der Technik ist in den Patentdokumenten US2008/0271779 A1 und DE 100 63 383 C1 offenbart.

Aufgabe der Erfindung ist es, die bekannten Sputtertargets zu verbessern, um gleichmäßige Sputterraten und Schichtdicken zu erzielen.

Die Aufgabe wird durch die Merkmale des unabhängigen Anspruchs 1 gelöst. Vorteilhafte Ausgestaltungen sind in den abhängigen Ansprüchen angegeben. Insbesondere ist die Erfindung charakterisiert durch ein rohrförmiges Sputtertarget mit einem Trägerrohr und einem auf dem Trägerrohr angeordneten Sputtermaterial auf der Basis von Indium, welches dadurch gekennzeichnet ist, dass das Sputtermaterial ein Gefüge aufweist mit einer mittleren Korngröße von weniger als 1 mm, gemessen als mittlerer Durchmesser der Körner auf der durch Sputtern aufgerauhten Oberfläche des Sputtermaterials.

Optional kann das Sputtermaterial mindestens ein Metall aus der Gruppe Zinn, Zink, Kupfer, Gallium enthalten. Das Sputtermaterial weist einen Anteil von höchstens 1 Gew.-% Kupfer und/oder Gallium auf. Desweiteren ist es zweckmäßig, dass das Gefüge eine mittlere Korngröße von kleiner 500 µm, bevorzugt kleiner 200 µm aufweist. Erfindungsgemäß ist es weiterhin, dass das Sputtermaterial eine Liquidustemperatur von höchstens 350 °C aufweist. Desweiteren ist es vorteilhaft, dass das Sputtermaterial die mittlere Korngröße über seine Dicke von der Targetoberfläche radial gemessen bis mindestens 1 mm über dem Trägerrohr aufweist. Dabei bezieht sich der Abstand von mindestens 1 mm auch bei den nachfolgenden entsprechenden Maßangaben auf den von der äußeren Oberfläche des Trägerrohres oder, sofern vorhanden, von der äußeren Oberfläche einer zwischen Trägerrohr und Sputtermaterial angeordneten Schicht (zum Beispiel Haftvermittler, Lotschicht) gemessenen Abstand, wobei dieser Abstand in radialer Richtung nach außen gemessen wird.

Das Metall des Sputtermaterials weist vorzugsweise eine Reinheit von mindestens 99,99 %, vorzugsweise von 99,999 % auf. In einer weiteren vorteilhaften Ausgestaltung weist das Sputtermaterial mindestens in einem Abstand von mehr als 1 mm von der dem Sputtermaterial zugewandten Oberfläche des Trägerrohres ein homogenes Gefüge auf.

Zweckmäßig ist es, dass mindestens 90 % der Körner eine Größe aufweist, die in einem Bereich von +/- 70% , bevorzugt +/- 50% um die mittlere Korngröße liegt. Es ist erfindungsgemäß, dass die Körner des Gefüges des Sputtermaterials jeweils einen kleinsten und einen größten Durchmesser aufweisen, wobei das Verhältnis von größtem zu kleinstem Durchmesser der Mehrzahl der Körner größer 2, insbesondere größer 3 ist. Dabei ist es sinnvoll, dass die Mehrzahl der Körner die Form einer in einer Richtung gestauchten Kugel aufweist.

Vorteilhafterweise kann die Dichte des Sputtermaterials mindestens 90 %, insbesondere mindestens 95 % der theoretischen Dichte betragen. Weiterhin ist es zweckmäßig, dass die einzelnen Körner des Sputtermaterials durch eine Oxidschicht oberflächlich passiviert sind. Vorzugsweise kann der Sauerstoffgehalt der Oxidschicht im Bereich von 50 bis 500 ppm, bevorzugt im Bereich von 70 bis 300ppm, bezogen auf das gesamte Sputtermaterial, betragen.

Das Trägerrohr kann aus einem unmagnetischen Material, vorzugsweise aus einer unmagnetischen Stahllegierung gebildet sein, wobei bevorzugt das Material des Trägerrohrs eine unmagnetische Stahllegierung ist und der Eisengehalt des Sputtermaterials um nicht mehr als 5 ppm, bevorzugt um nicht mehr als 1 ppm über dem Eisengehalt des Ausgangsmaterials des Sputtermaterials liegt, gemessen in einen Mindestabstand von 1mm vom Trägerrohr oder einer Haftvermittlerschicht, die gegebenenfalls zwischen Sputtermaterial und Trägerrohr angeordnet ist.

Das Sputtertarget kann vorzugsweise eine Länge von mindestens 500 mm aufweisen.

Vorzugsweise kann das Sputtertarget zur Abscheidung von Photovoltaik-Absorberschichten direkt oder in einem mehrstufigen Prozess oder zur Abscheidung oxidischer Schichten über reaktives Sputtern verwendet werden.

Generell kann mit der Erfindung ein hochreines Rohrtarget (mit einem Reinheitsgrad von 99,99 bis 99,999%) aus Indium (In) oder einer In-Legierung bereitgestellt werden, mit einem feinen Korn und einer hohe Dichte. Außerdem kann der Sauerstoffgehalt so gewählt werden, dass es einerseits beim Sputtern nicht zu einem Funkenüberschlag an der Kathode (arcing) oder Nadel- und Pickelbildung kommt, anderseits dass das Targetmaterial im Falle eines Funkenüberschlags aber auch nicht gleich großflächig aufschmilzt. Damit wird ein gutes Verhältnis von Einsatzmaterial zu nutzbarem Targetmaterial erhalten.

Das erfindungsgemäße Sputtertarget kann also vorzugsweise eines oder mehrere der folgenden Merkmale aufweisen:
- Reinheit mindestens 99,99 %, vorzugsweise mindestens 99,999 %,
- feinkörniges Gefüge mit einer mittleren Korngröße kleiner 1 mm, vorzugsweise kleiner 500 µm, vorzugsweise kleiner 200 µm gemessen aus dem mittleren Durchmesser der Indium-Körner auf der sputtergeätzten Rohroberfläche, wobei diese Korngröße von der Targetoberfläche bis 1mm über dem Trägerrohr eingehalten wird,
- homogenes Gefüge in Targetlänge und Targetdicke (mit Ausnahme des letzten 1 mm vor dem Trägerrohr) mit einer Korngröße, die sich für 90 % der Körner in einer Spanne von +- 70 %, bevorzugt +- 50 % um die mittlere Korngröße bewegt
- Kornform mit einem linsenförmigen Querschnitt mit einem Verhältnis von Durchmesse/Dicke größer 2
- Dichte größer als 90 %, bevorzugt 95 % der theoretischen Dichte
- oberflächliche Passivierung der einzelnen Körner durch eine dünne Oxidschicht zur Verringerung der Aufschmelzneigung im Fall von Funkenüberschlag
- Sauerstoffgehalt im Bereich von 50 bis 500 ppm, vorzugsweise im Bereich von 70 bis 300 ppm.
- Zusammensetzung: Indium (nebst Verunreinigungen), Indium-Legierungen mit Schmelztemperatur kleiner 300 °C, insbesondere In-Sn
- Verbund aus Indium-Material und einem Edelstahl-Trägerrohr, wobei der Eisengehalt des Sputtertargetmaterials gegenüber dem für dessen Herstellung eingesetzten Ausgangsmaterial um nicht mehr als 5 ppm / 1 ppm angestiegen ist.

Nachfolgend wird die Erfindung beispielhaft anhand von Zeichnungen beschrieben. In den Zeichnungen zeigt
Figur 1a: Feinkörniges Target mit erfindungsgemäßem Gefüge entsprechend Verfahren 1.
Figur 1b: Sputtergeätzte Oberfläche eines In-Rohrtargets entsprechend Verfahren 1
Figur 2: Sputterrate als Funktion der Zeit für ein erfindungsgemäßes Target bei einer spezifischen Leistung von 4kW/m
Figur 3: Sputtertarget nach Verfahren 2 (Vergleichstarget) mit grobkörnigem Gefüge
Figur 4: Sputterrate als Funktion der Zeit für ein Target nach Verfahren 2 (Vergleichstarget) bei einer spezifischen Leistung von 4kW/m

### 1. Verfahren für erfindungsgemäßes Rohrtarget:

Hochreines Indium (99,999%) wird in einem Tiegel erschmolzen. Ein mit einer rauen Haftvermittlerschicht versehenes Trägerrohr wurde auf einer Drehvorrichtung montiert. Das schmelzflüssige Indium-Metall wurde über eine Zuleitung einer Zerstäubungsdüse zugeführt und dort durch die Wirkung eines Gases versprüht. Die schmelzflüssigen Tropfen treffen auf das rotierende Trägerrohr und durch eine Relativbewegung zwischen Trägerrohre und Sprühdüse wird somit über die Zeit in mehreren Lagen eine dicke metallische Indium-Schicht auf dem Trägerrohr aufgetragen.

Die optimale Temperatur für die Schmelze ist in Abhängigkeit von Düsengeometrie, Spritzabstand und Umfangsgeschwindigkeit des Trägerrohres in einigen Vorversuchen zu ermitteln. Als günstig haben sich Temperaturen im Bereich 170-230°C erwiesen.

Als Zerstäubungsgas kommen sowohl Schutzgase wie Argon, Stickstoff als auch Luft in Frage. Durch die Wahl des Gases lässt sich in Verbindung mit der Schmelztemperatur und dem Spitzabstand dann der effektive Sauerstoffgehalt im Sputtertargetmaterial einstellen. Auch hier sind je nach gewählter Lösung wieder einige Vorversuche erforderlich.

Der so hergestellt Rohrrohling weist noch eine spritzraue Oberfläche auf, die durch Überdrehen entfernt wurde.

Es ergab sich ein erfindungsgemäßes Gefüge, wenn man die Herstellparameter entsprechend wählt. Dies ist für den Fachmann im Rahmen einer Reihe von wenigen Versuchen ohne Schwierigkeiten möglich, wobei besonderes Augenmerk auf die Temperatur und Atmosphäre gegeben werden muss, um die erfindungsgemäßen Eigenschaften zu Korngröße und Sauerstoffgehalt zu erreichen. Bei falscher Wahl der Beschichtungsparameter ergab sich eine zu geringe Dichte (kleiner 90 %) oder ein zu hoher Sauerstoffgehalt (größer 500 ppm).

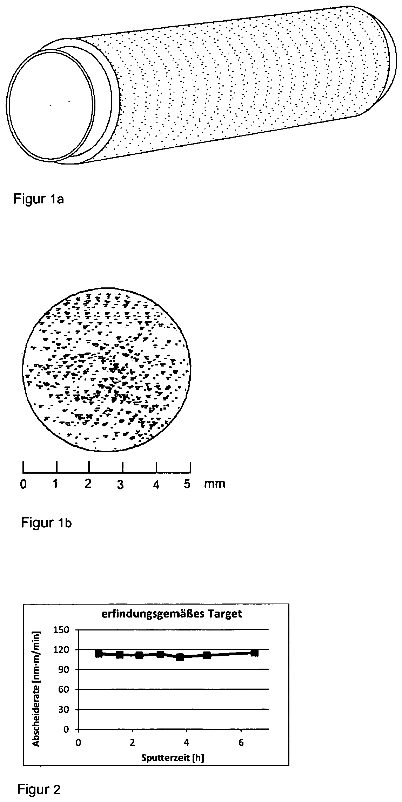

Die hergestellten Rohre wiesen ein feinkörniges Gefüge auf, das je nach Verfahrensparametern eine mittlere Korngröße von 50 bis 500 µm aufwies. In den meisten Fällen ergaben sich mittlere Korngrößen von kleiner 200 µm. In jedem Fall lag die Korngröße unter 1mm (Fig. 1a, 1b). Aufgrund der schichtweisen Herstellung der erfindungsgemäßen Sputtertargets ist das Gefüge über die Dicke und Mantelfläche des Sputtertargets homogen. Die mittlere Korngröße variierte über das Sputtertarget in Länge und Dicke um höchstens +- 70 %, meistens jedoch nur um weniger als +- 50 %. Außerdem waren die Körner von abgeflachter Form mit einem Verhältnis von Durchmesser zu Dicke im Bereich von üblicherweise mehr als 2, häufig mehr als 3. Wegen der feinen und gleichmäßigen Korngröße sowie der flachen Kornform ergabt sich beim Sputtern für jedes Korn nur eine kurze Expositionszeit, bis es abgetragen wurde. Dies hat zur Folge, dass sich die oben beschriebene Nadelstruktur nicht großflächig ausbilden kann. Somit ergaben sich sehr stabile Sputterraten (Abscheideraten) (siehe Fig. 2). Bei günstigen Ausführungen konnten selbst für Rohrtargets mit 15 mm dicker Indiumauflage spezifische Sputterbelastungen bis hinauf zu etwa 20 kW/m realisiert werden. Das Sputtertarget kann also mit einer spezifischen Leistung von mindestens 15kW/m, gegebenenfalls sogar mit 20 kW/m oder mehr, betrieben werden.

Mit geeigneter Wahl der Prozessbedingungen wurden Sauerstoffwerte im Bereich von 50 bis 500 ppm erzielt. Es wurde überraschend festgestellt, dass während des Sputtern gezielt ausgelöste Funkenentladungen (arcing) um so tiefere Spuren in dem niedrig schmelzenden Indium hinterlassen, je niedriger der Sauerstoffgehalt ist. Die Oxidhülle um die Körner führt also zu einer Stabilisierung der Sputtertargetoberfläche während eines kurzzeitigen Aufschmelzens. Vorteilhafte Sauerstoffgehalte haben sich im Bereich von 70 bis 300 ppm ergeben. Mit gewissen Einschränkungen sind auch noch 50 bis 500 ppm einsetzbar. Wichtig ist dabei, dass der Sauerstoff als Oxidhülle um die Partikel bzw. Körner vorliegt. Bei zu niedrigen O₂-Werten tritt der positive Effekt der Schmelzstabilisierung nicht mehr auf. Bei zu hohen O₂-Werten treten durch die Oxide ausgelöste Instabilitäten auf, die dann selbst zu unerwünschten Entladungen führen. Der Eisen-Gehalt der so hergestellten Targets lag bei weniger als 1 ppm, wenn die Probe mindestens 1 mm oberhalb des Trägerrohres bzw. der zwischen Trägerrohr und Sputtermaterial angeordneten Haftschicht entnommen wurde. Die Verunreinigungen wurden an in Säure gelöstem Sputtertargetmaterial gemessen mittels optischer Emmissionsspektrometrie (OES) mit Anregung durch induktiv eingekoppeltes Plasma (ICP).

Alternativ können statt reinem Indium auch Indium-Legierungen wie zum Beispiel In:Cu, In:Ga, In:Sn oder In:Zn oder Mischungen daraus eingesetzt werden. Das erfindungsgemäße Verfahren funktionierte erfolgreich, solange die Liquidustemperatur der Legierungen nicht über 350 °C lag. Bei In:Ga sind wegen des tief liegenden Eutektikums allerdings nur Zusätze von maximal 5 bis 10 Gew.-% sinnvoll. Bei In:Cu ist man wegen der schnell ansteigenden Liquidustemperaur auf maximal ca. 5 Gew.-% beschränkt.

### 2. Verfahren für alternatives Rohrtarget (Vergleichsbeispiel)

Die gießtechnische Herstellung erfolgte im Vergleichsbeispiel wie für Sn-Rohre beschrieben in EP 1186682 B1, wobei jedoch 99,999 % reines Indium eingesetzt wurde. Erschmelzen und Abguss des Indiums erfolgte bei 190 °C aus einem Tiegel in eine vorgewärmte Stahlform, die das Trägerrohr umschließt, wobei die Stahlform am Fuß über ein Dichtteil mit dem Trägerrohr verbunden war. Außerdem war die Gussform mit Schutzgas gespült, um Oxidation zu verhindern. Zur besseren Verbindung des Indium mit dem Trägerrohr wurde das Trägerrohr mit einer Nickel-basierten Haftschicht versehen, die mit Indium vorbelotet war. Nach dem Abgießen wurde das Trägerrohr von innen beginnend vom Fuß mit eingeblasener Luft gekühlt, so dass sich eine von unten nach oben steigende Erstarrung ergab.

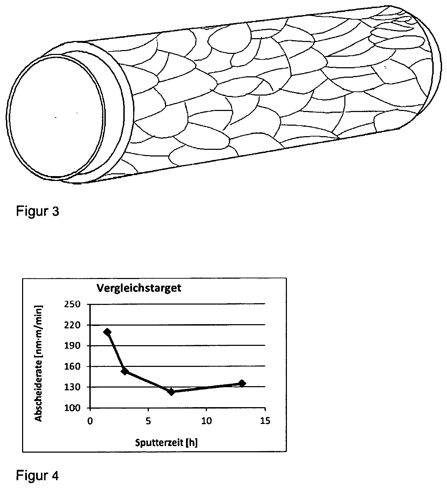

Dieses Verfahren ergab ein grobkörniges Indium-Rohrtarget (Fig. 3), wobei sich außerdem wegen der langen Zeit, in der die Schmelze mit dem Trägerrohr und der Gießform in Berührung kam, auch noch ein zu hoher Eisengehalt von 50 ppm ergab. Das grobe Gefüge führte zu der in Fig. 4 gezeigten zeitlich stark fallenden Sputterrate (Abscheiderate), da sich auf der Oberfläche die schon erwähnte Nadelstruktur ausbildete. Das Sputtertarget sputterte ohne nennswertes Arcing. Allerdings führte der niedrige Sauerstoffgehalt von weniger als 50ppm dazu, das ein künstlich erzeugter Funkenüberschlag tiefe Löcher in der Targetoberfläche hinterließ. Da es im großtechnischen Sputter-prozess immer wieder externe Gründen für das Arcing gibt, stellt dies gerade bei einem so niedrig schmelzenden Material wie Indium ein erhöhtes Risiko dar.

## Patentansprüche

1. Rohrförmiges Sputtertarget mit einem Trägerrohr und einem auf dem Trägerrohr angeordneten Sputtermaterial,
wobei das Sputtermaterial aus reinem Indium oder Indium-Kupfer-, Indium-Gallium-, Indium-Zinn- oder Indium-Zink-Legierungen oder Mischungen daraus besteht,
wobei das Sputtermaterial höchstens 1 Gew.-% Kupfer und/oder Gallium, einen Sauerstoffgehalt im Bereich von 50 bis 500 ppm und einen Eisen-Gehalt von weniger als 1 ppm aufweist,
wobei die Liquidustemperatur der Legierungen nicht über 350°C liegt, und wobei das Sputtermaterial ein Gefüge aufweist mit einer mittleren Korngröße von weniger als 1 mm, gemessen als mittlerer Durchmesser der Körner auf der durch Sputtern aufgerauhten Oberfläche des Sputtermaterials,
**dadurch gekennzeichnet, dass**
die Körner des Gefüges des Sputtermaterials jeweils einen kleinsten und einen größten Durchmesser aufweisen, wobei das Verhältnis von größtem zu kleinstem Durchmesser von mehr als 50% der Körner größer 2 ist,
wobei das Sputtertarget erhältlich ist durch ein Verfahren, indem das Sputtermaterial in schmelzflüssiger Form über eine Zuleitung einer Zerstäubungsdüse zugeführt wird, dort durch die Wirkung eines Gases versprüht wird, die so gebildeten, schmelzflüssigen Tropfen auf das Trägerrohr treffen, welches rotiert, und durch eine Relativbewegung zwischen Trägerrohr und Zerstäubungsdüse somit über die Zeit in mehreren Lagen eine Sputtertarget-Schicht auf dem Trägerrohr aufgetragen wird.

2. Sputtertarget nach Anspruch 1, **dadurch gekennzeichnet, dass** das Gefüge eine mittlere Korngröße von kleiner 500 µm aufweist.

3. Sputtertarget nach Anspruch 2, **dadurch gekennzeichnet, dass** das Gefüge eine mittlere Korngröße von kleiner 200 µm aufweist

4. Sputtertarget nach mindestens einem der Ansprüche 1 bis 3, **dadurch gekennzeichnet, dass** das Sputtermaterial die mittlere Korngröße über seine Dicke von der Targetoberfläche radial gemessen bis mindestens 1 mm über dem Trägerrohr aufweist.

5. Sputtertarget nach mindestens einem der Ansprüche 1 bis 4, **dadurch gekennzeichnet, dass** das Metall des Sputtermaterials eine Reinheit von mindestens 99,99 % aufweist.

6. Sputtertarget nach mindestens einem der Ansprüche 1 bis 5, **dadurch gekennzeichnet, dass** das Sputtermaterial mindestens in einem Abstand von mehr als 1 mm von der dem Sputtermaterial zugewandten Oberfläche des Trägerrohres ein homogenes Gefüge aufweist.

7. Sputtertarget nach mindestens einem der Ansprüche 1 bis 6, **dadurch gekennzeichnet, dass** mindestens 90 % der Körner eine Größe aufweist, die in einem Bereich von +/-70% um die mittlere Korngröße liegt.

8. Sputtertarget nach mindestens einem der Ansprüche 1 bis 7, **dadurch gekennzeichnet, dass** die Mehrzahl der Körner die Form einer in einer Richtung gestauchten Kugel aufweist.

9. Sputtertarget nach mindestens einem der Ansprüche 1 bis 8, **dadurch gekennzeichnet dass** die Dichte des Sputtermaterials mindestens 90 % der theoretischen Dichte beträgt.

10. Sputtertarget nach mindestens einem der Ansprüche 1 bis 9, **dadurch gekennzeichnet dass** die einzelnen Körner des Sputtermaterials durch eine Oxidschicht oberflächlich passiviert sind.

11. Sputtertarget nach mindestens einem der Ansprüche 1 bis 10, **dadurch gekennzeichnet, dass** das Trägerrohr aus einem unmagnetischen Material gebildet ist.

12. Sputtertarget nach Anspruch 11, **dadurch gekennzeichnet, dass** das Material des Trägerrohrs eine unmagnetische Stahllegierung ist und der Eisengehalt des Sputtermaterials um nicht mehr als 5 ppm über dem Eisengehalt des Ausgangsmaterials des Sputtermaterials liegt, gemessen in einen Mindestabstand von 1 mm vom Trägerrohr oder einer Haftvermittlerschicht, die gegebenenfalls zwischen Sputtermaterial und Trägerrohr angeordnet ist.

13. Sputtertarget nach mindestens einem der Ansprüche 1 bis 12, **dadurch gekennzeichnet, dass** es eine Länge von mindestens 500 mm aufweist.

## Claims

1. Tubular sputtering target having a support tube and a sputtering material arranged on the support tube,
wherein the sputtering material consists of pure indium or indium-copper, indium-gallium, indium-tin or indium-zinc alloys or mixtures thereof,
wherein the sputtering material has at most 1 wt. % copper and/or gallium, an oxygen content in the range of 50 to 500 ppm and an iron content of less than 1 ppm, wherein the liquidus temperature of the alloys does not exceed 350°C, and
wherein the sputtering material has a microstructure with an average grain size of less than 1 mm, measured as the average diameter of the grains on the surface of the sputtering material roughened by the sputtering,
**characterised in that**
the grains of the microstructure of the sputtering material each have a smallest and a largest diameter, the ratio of the largest to the smallest diameter of more than 50% of the grains being greater than 2,
wherein the sputtering target is obtainable by a process in which the sputtering material is fed in molten form via a feed line to an atomising nozzle and is sprayed there by the action of a gas, the molten drops formed in this way strike the carrier tube, which rotates, and a sputtering target layer is thus applied to the carrier tube in several layers over time by a relative movement between the carrier tube and the spraying nozzle.

2. Sputtering target according to claim 1, **characterised in that** the microstructure includes an average grain size of less than 500 µm.

3. Sputtering target according to claim 2, **characterised in that** the microstructure includes an average grain size of less than 200 µm.

4. Sputtering target according to at least one of claims 1 to 3, **characterised in that** the sputtering material includes the average grain size measured radially across its thickness from the target surface to at least 1 mm above the support tube.

5. Sputtering target according to at least one of claims 1 to 4, **characterised in that** the metal of the sputtering material has a purity of at least 99.99%.

6. Sputtering target according to at least one of claims 1 to 5, **characterised in that** the sputtering material has a homogeneous microstructure at least at a distance of more than 1 mm from the surface of the support tube facing the sputtering material.

7. Sputtering target according to at least one of claims 1 to 6, **characterised in that** at least 90% of the grains include a size which is in a range of +/-70% around the mean grain size.

8. Sputtering target according to at least one of claims 1 to 7, **characterised in that** the majority of the grains includes the shape of a sphere compressed in one direction.

9. Sputtering target according to at least one of claims 1 to 8, **characterised in that** the density of the sputtering material is at least 90% of the theoretical density.

10. Sputtering target according to at least one of claims 1 to 9, **characterised in that** the individual grains of the sputtering material are passivated on the surface by an oxide layer.

11. Sputtering target according to at least one of claims 1 to 10, **characterised in that** the support tube is formed from a non-magnetic material.

12. Sputtering target according to claim 11, **characterised in that** the material of the support tube is a non-magnetic steel alloy and the iron content of the sputtering material is not more than 5 ppm above the iron content of the starting material of the sputtering material measured at a minimum distance of 1 mm from the support tube or an adhesion promoting layer optionally disposed between the sputtering material and the support tube.

13. Sputtering target according to at least one of claims 1 to 12, **characterised in that** it includes a length of at least 500 mm.

## Revendications

1. Cible de pulvérisation tubulaire comprenant un tube de support et un matériau de pulvérisation disposé sur le tube de support,
dans laquelle le matériau de pulvérisation est constitué d'indium pur ou d'alliages d'indium-cuivre, d'indium-gallium, d'indium-étain ou d'indium-zinc ou de mélanges de ceux-ci,
dans lequel le matériau de pulvérisation a au maximum 1 % en poids de cuivre et/ou de gallium, une teneur en oxygène comprise entre 50 et 500 ppm et une teneur en fer inférieure à 1 ppm,
dans lequel la température du liquidus des alliages ne dépasse pas 350°C, et
dans lequel le matériau de pulvérisation a une microstructure dont la taille moyenne de grain est inférieure à 1 mm, mesurée comme le diamètre moyen des grains sur la surface du matériau de pulvérisation rendue rugueuse par la pulvérisation, **caractérisée en ce que**
les grains de la structure du matériau de pulvérisation ont chacun un diamètre plus petit et un diamètre plus grand, le rapport entre le diamètre le plus grand et le plus petit de plus de 50 % des grains étant supérieur à 2,
la cible de pulvérisation pouvant être obtenue par un procédé dans lequel le matériau de pulvérisation est amené sous forme fondue par une conduite d'alimentation à une buse de pulvérisation, y est pulvérisé sous l'action d'un gaz, les gouttelettes fondues ainsi formées heurtent le tube porteur en rotation, et une couche de cible de pulvérisation est ainsi appliquée sur le tube porteur en plusieurs couches dans le temps par un mouvement relatif entre le tube porteur et la buse de pulvérisation.

2. Cible de pulvérisation de la revendication 1, **caractérisée en ce que** la microstructure a une taille moyenne de grain inférieure à 500 µm.

3. Cible de pulvérisation selon la revendication 2, **caractérisée en ce que** la microstructure a une taille moyenne de grain inférieure à 200 µm

4. Cible de pulvérisation selon au moins l'une des revendications 1 à 3, **caractérisée en ce que** le matériau de pulvérisation a la taille moyenne des grains sur son épaisseur mesurée radialement depuis la surface de la cible jusqu'à au moins 1 mm au-dessus du tube de support.

5. Cible de pulvérisation d'au moins une des revendications 1 à 4, **caractérisée en ce que** le métal du matériau de pulvérisation a une pureté d'au moins 99,99 %.

6. Cible de pulvérisation selon au moins l'une des revendications 1 à 5, **caractérisée en ce que** le matériau de pulvérisation présente une structure homogène au moins à une distance de plus de 1 mm de la surface du tube porteur tournée vers le matériau de pulvérisation.

7. Cible de pulvérisation d'au moins une des revendications 1 à 6, **caractérisée en ce qu'**au moins 90 % des grains ont une taille qui se situe dans une fourchette de +/-70 % autour de la taille moyenne des grains.

8. Cible de pulvérisation selon au moins une des revendications 1 à 7, **caractérisée en ce que** la pluralité de grains a la forme d'une sphère comprimée dans une direction.

9. Cible de pulvérisation selon au moins une des revendications 1 à 8, **caractérisée en ce que** la densité du matériau de pulvérisation est d'au moins 90 % de la densité théorique.

10. Cible de pulvérisation selon au moins une des revendications 1 à 9, **caractérisée en ce que** les grains individuels du matériau de pulvérisation sont passivés en surface par une couche d'oxyde.

11. Cible de pulvérisation selon au moins une des revendications 1 à 10, **caractérisée en ce que** le tube de support est formé d'un matériau non magnétique.

12. Cible de pulvérisation selon la revendication 11, **caractérisée en ce que** le matériau du tube de support est un alliage d'acier non magnétique et la teneur en fer du matériau de pulvérisation ne dépasse pas 5 ppm de la teneur en fer du matériau de départ du matériau de pulvérisation, mesurée à une distance minimale de 1 mm du tube de support ou d'une couche d'agent de liaison, le cas échéant, interposée entre le matériau de pulvérisation et le tube de support.

13. Cible de pulvérisation selon au moins une des revendications 1 à 12, **caractérisée en ce qu'**elle a une longueur d'au moins 500 mm.
